Europäisches Patentamt

European Patent Office

Office européen des brevets

(11) Veröffentlichungsnummer: **0 212 207**
**A1**

## (12) EUROPÄISCHE PATENTANMELDUNG

(21) Anmeldenummer: 86109393.8

(22) Anmeldetag: 09.07.86

(51) Int. Cl.⁴: **H01L 29/72** , H01L 29/04

(30) Priorität: 19.07.85 DE 3525868

(43) Veröffentlichungstag der Anmeldung:
**04.03.87 Patentblatt 87/10**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Wieder, Armin, Dr.**
**Zentnerstrasse 20**
**D-8000 München 40(DE)**
Erfinder: **Bieger, Johannes, Dr.**
**Rabistrasse 18**
**D-8000 München 80(DE)**

(54) **Bipolartransistorstruktur für integrierte Schaltungen mit hohen Schaltgeschwindigkeiten und Verfahren zu ihrer Herstellung.**

(57) Die erfindungsgemäße Bipolartransistorstruktur ist gekennzeichnet durch auf einem Halbleitersubstrat (1) in Schichtenfolge übereinander angeordnete, aus dotiertem Polysilizium (4, 6, 8) bestehenden Kollektor-, Basis-und Emitterzone. Vorzugsweise enthalten die Kollektor-und Emitterzonen zusätzlich eine Metallsilizidschicht (3, 9) und der Basisanschluß ist ringförmig ausgebildet. Die Anordnung zeichnet sich durch die einfache Art ihrer Anschlüsse und durch niedrige Emitter-, Basis-und Kollektorwiderstände aus. Durch die Eliminierung der parasitären pn-Übergänge werden Schaltzeiten von 10 bis 20 ps erreicht. Die Anordnung wird verwendet in Kombination mit der Herstellung von CMOS-Schaltungen.

FIG 4

EP 0 212 207 A1

**Bipolartransistorstruktur für integrierte Schaltungen mit hohen Schaltgeschwindigkeiten und Verfahren zu ihrer Herstellung.**

Die Erfindung betrifft eine Bipolartransistorstruktur für integrierte Schaltungen mit hohen Schaltgeschwindigkeiten.

Die Schaltgeschwindigkeit bekannter Bipolartransistoren ist in erheblichem Maß durch parasitäre Kapazitäten und Bahnwiderstände begrenzt. Diese entstehen letztlich dadurch, daß die einzelnen, den Transistor bildenden Gebiete im Volumen eines Halbleitersubstrates liegen, während die elektrische Verbindung dieser Gebiete mit anderen Schaltungselementen im allgemeinen nur von der Substratoberfläche aus erfolgen kann. Somit sind noch elektrisch leitende Anschlußbahnen im Substratvolumen nötig.

Eine Reduktion der parasitären Lasten wurde bisher durch die Verkleinerung der Anschlußbahngebiete erreicht. Das ist möglich durch die Verbesserung der Fotolithographie in Richtung kleinerer Strukturen oder durch den Einsatz von Selbstjustierungsverfahren, wie sie beispielsweise in einem Aufsatz von A. W. Wieder "Self-aligned Bipolar Technology -New Chances for Very-High-Speed Digital Integrated Circuits" in den Siemens Forschungs-und Entwicklungs-Berichten 13, Seiten 246 bis 252 (1984) beschrieben sind. Außerdem kann bei der Einstellung der Dotierungsverhältnisse ein Kompromiß zwischen optimaler Funktion des eigentlichen Transistors und Minimierung der parasitären Lasten getroffen werden. Diese Strukturen erfordern einen erheblichen technischen Aufwand.

Die Erfindung dient der Lösung der Aufgabe, einen Transistoraufbau in Bipolarstruktur anzugeben, der die oben angegebenen Nachteile vermeidet, der einfach herstellbar ist und dessen Herstellung mit den bestehenden Prozessen zur Fertigung von komplementären MOS-Transistoren (CMOS) kombinierbar ist.

Diese Aufgabe wird durch eine Bipolartransistorstruktur gelöst, die dadurch gekennzeichnet ist, daß auf einem Halbleitersubstrat in Schichtenfolge übereinander die aus dotiertem Polysilizium bestehenden Kollektor-, Basis-und Emitterzonen angeordnet sind. Dabei liegt es im Rahmen der Erfindung, daß die Kollektor-und die Emitterzone zusätzlich eine Metallsilizidschicht enthält und der Basisanschluß ringförmig ausgebildet ist.

Gemäß einem Ausführungsbeispiel nach der Lehre der Erfindung befindet sich die vorzugsweise aus Tantalsilizid bestehende Metallsilizidschicht auf der, der Basiszone abgewandten Seite parallel zur Emitter-bzw. Kollektorschicht.

Weitere Ausgestaltungen der Erfindung ergeben sich aus den Unteransprüchen.

Durch die erfindungsgemäße Bipolarstruktur ergibt sich die Möglichkeit neben der einfachen Art ihrer Herstellung die elektrisch leitenden Anschlüsse aus dem Substratvolumen auf die Substratoberfläche zu verlagern und seitlich anzubringen.

Weitere Vorteile sind:

1. Es können sehr niedrige Emitter-, Basis- und Kollektor widerstände durch die Verwendung von Silizid in Emitter und Kollektor und durch den ringförmigen Anschluß der Basis erreicht werden.

2. Parasitäre p-n-Übergänge und damit verbundene Kapazitäten werden eliminiert.

3. Dadurch sind Schaltzeiten von 10 bis 20 ps ( = Pikosekunden) erreichbar.

4. Durch die hohe Basisdotierung werden Emitter-Kollektor-Kurzschlüsse vermieden.

5. Durch den einfachen Herstellungsprozeß wird eine hohe Fertigungsausbeute erzielt.

6. Wegen des einfachen Herstellungsprozesses bietet sich eine Kombination mit bestehenden Prozessen zur Herstellung von komplementären MOS-Transistoren (CMOS) an.

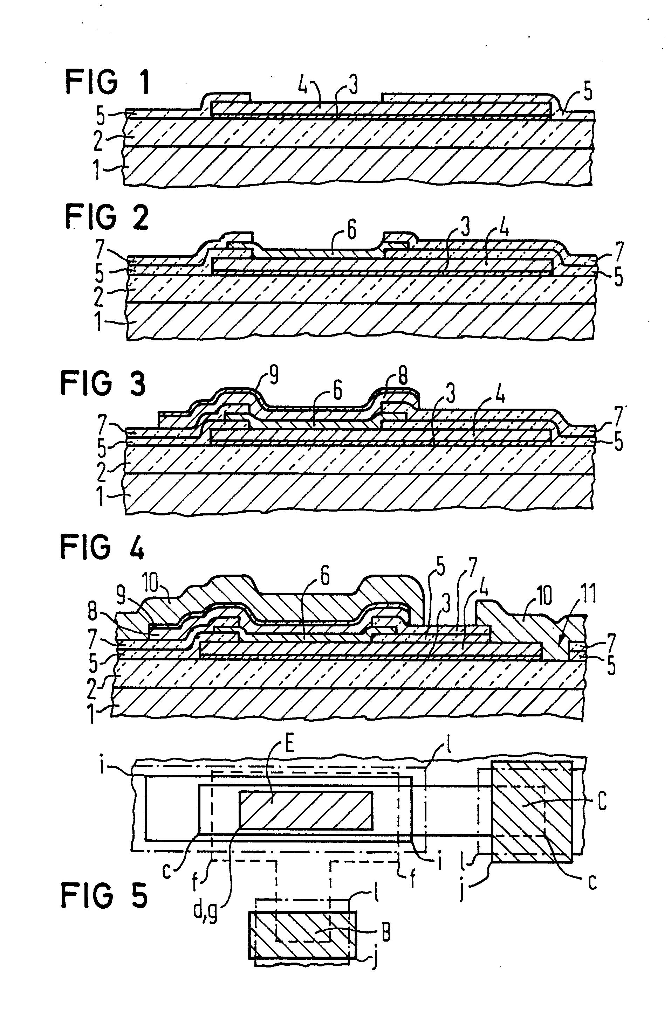

Im folgenden wird die Erfindung anhand der Figuren 1 bis 5 noch näher erläutert. Dabei zeigen

die Figuren 1 bis 4 im Schnittbild aufeinanderfolgende, erfindungswesentliche Herstellungsschritte bis zu einer Bipolartransistorstruktur und die Figur 5 das Layout dieser Struktur.

Für gleiche Teile gelten in allen Figuren gleiche Gezugszeichen.

Gemäß Figur 1 beginnt das Verfahren zur Herstellung einer Bipolartransistorstruktur mit einem Halbleitersubstrat 1 aus n-dotiertem Silizium, auf welches zur Isolation des gesamten Transistors eine erste $SiO_2$-Schicht 2 in einer Schichtdicke von 500 bis 1000 nm aufgebracht wird. Darauf wird ganzflächig eine Doppelschicht bestehend aus einer ersten Tantalsilizidschicht 3 (10 bis 20 nm) und einer mit Arsen dotierten ersten Polysiliziumschicht 4 (100 bis 200 nm) abgeschieden. Die Doppelschicht 3, 4 wird dann mittels Fotolithographie zur Kollektorzone des Transistors strukturiert. Darauf wird eine zweite $SiO_2$ -Schicht 5 abgeschieden und mittels Fototechnik so strukturiert, daß der über der Kollektorzone 3, 4 liegende Basisbereich (6) freigelegt ist.

Gemäß Figur 2 wird nun die aus p-dotiertem Silizium (Bor) bestehende Basisschicht 6 (zweite Polyschicht) durch Abscheiden und Strukturierung nach erfolgter Fotolackmaskierung hergestellt. Auf dieser Anordnung wird eine dritte SiO₂-Schicht 7 erzeugt und in dieser der über der Kollektorzone 3, 4 und der Basiszone 6 liegende Emitterbereich (8, 9) freigeätzt.

Figur 3: Nach dem Abscheiden einer dritten, aus n-dotiertem Polysilizium (Arsen) bestehenden Schicht 8 wird ganzflächig darauf eine zweite Tantalsilizidschicht 9 aufgebracht und die Doppelschicht 8, 9 zur Emitterzone strukturiert, und zwar so, daß die Emitterzone 8, 9 beidseitig die Basiszone 6 und einseitig die Kollektorzone 3, 4 überlappt.

Die Figur 4 zeigt das Anbringen der aus Aluminium bestehenden Zuleitungen 10 zu den Transistorzonen (C, B, E) nach vorheriger Kontaktlochätzung (siehe Pfeil 11) im Kollektorbereich.

Aus der Figur 5 sind die einzelnen Maskenschritte zur Herstellung der Transistorstruktur nach Figur 1 bis 4 ersichtlich. Die schraffierten Bereiche kennzeichnen die Kontaktlochbereiche für den Kollektor (C)-, Emitter (E)-und Basisanschluß (B), der ringförmig ausgebildet ist.

Als Bezugszeichen sind die im Patentanspruch 13 angegebenen Verfahrensmerkmale, die die jeweiligen Maskierungsschritte enthalten, verwendet.

Das erfindungsgemäße Verfahren kann insofern variiert werden, als die erste, auf dem Substrat 1 aufgebrachte SiO₂-Schicht 2 nicht das ganze Substrat bedeckt, sondern nur teilweise, so daß der Kollektor (3, 4) mit dem Substrat 1 in leitender Verbindung steht. Dies wird erreicht durch eine teilweise Oxidation des Substrats unter Verwendung einer aus Siliziumnitrid bestehenden Maske, wie beim sogenannten LOCOS-Verfahren.

Eine weitere Version des erfindungsgemäßen Verfahrens ist, die zweite Tantalsilizidschicht 9 erst vor der Aluminiumbeschichtung 10 aufzubringen und dann auch mit dieser zu strukturieren.

Zur Vereinfachung des Prozesses kann auch in einer Version des erfindungsgemäßen Verfahrens die dritte Oxidschicht 7 eingespart werden.

Die Dotierung der Polysiliziumschichten 4, 6, 8 mit Arsen bzw. Bor kann wahlweise schon während des Abscheideprozesses erfolgen ("dotierte Abscheidung"); sie kann aber auch durch Implantation von Ionen nach der Abscheidung und anschließende Temperung zur Verteilung und elektrischen Aktivierung des Dotierstoffes im Silizium vorgenommen werden. Die elektrischen Eigenschaften des Transistors, zum Beispiel das Sperrverhalten von E-B-Dioden und B-C-Dioden können durch die Dotierstoffkonzentration sowie durch die Kornstruktur der Polysiliziumschichten den jeweiligen Erfordernissen angepaßt werden. So läßt sich zum Beispiel das Sperrverhalten dadurch verbessern, daß die Siliziumschicht (4, 6, 8) amorph abgeschieden und durch anschließende Schockausheilung kristallisiert wird. Nähere Einzelheiten sind aus einem Aufsatz von F. S. Becker et. al. "Low resistance polycrystalline silicon by boron or arsenic implantation and thermal crystallization of amorphously deposited films" in J. Appl. Phys. 56 (4), Seiten 1233 bis 1236 (1984), oder aus einem Aufsatz von H. Schaber et. al. "Laser annealing study of the grain size effect in polycrystalline silicon Schottky diodes" in J. Appl. Phys. 53 (12), Seiten 8827 bis 8834 (1982), zu entnehmen.

Bezugszeichenliste

1 Halbleitersubstrat
2 1. SiO₂-Schicht
3 1. Tantalsilizidschicht
4 mit As dotierte erste Polysiliziumschicht
5 2. SiO₂-Schicht
6 Basisbereich, 2. Polysiliziumschicht
7 3. SiO₂-Schicht
8 mit As dotierte 3. Polysiliziumschicht
9 2. Tantalsilizidschicht
10 Aluminium-Zuleitungen
11 Kontaktlochätzung
C Kollektoranschluß
B Basisanschluß
E Emitteranschluß

**Ansprüche**

1. Bipolartransistorstruktur für integrierte Schaltungen mit hohen Schaltgeschwindigkeiten, **gekennzeichnet durch** auf einem Halbleitersubstrat (1) in Schichtenfolge übereinander angeordnete, aus dotiertem Polysilizium (4, 6, 8) bestehenden Kollektor-, Basis-und Emitterzonen.

2. Bipolartransistorstruktur nach Anspruch 1, **dadurch gekennzeichnet,** daß die Kollektor-und Emitterzone zusätzlich eine Metallsilizidschicht (3, 9) enthält.

3. Bipolartransistorstruktur nach Anspruch 1 oder 2, **dadurch gekennzeichnet,** daß der Basisanschluß ringförmig ausgebildet ist.

4. Bipolartransistorstruktur nach mindestens einem der Ansprüche 1 bis 3, **gekennzeichnet durch** Emitter-und Kollektorzone bestehend aus n⁺-dotiertem Polysilizium (4, 8) mit auf der, der Basiszone (6) abgewandten Seite parallel zur Emitter (8) und Kollektorschicht (4) liegender Metallsilizidschicht (3, 9).

5. Bipolartransistorstruktur nach Anspruch 4, **dadurch gekennzeichnet,** daß die Metallsilizidschicht (3, 9) aus Tantalsilizid besteht.

6. Bipolartransistorstruktur nach mindestens einem der Ansprüche 1 bis 5, **dadurch gekennzeichnet,** daß das Schichtdickenverhältnis der Metallsilizidschicht (3, 9) im Vergleich zur Polysiliziumschicht (4, 8) im Bereich von 1 : 3 bis 1 : 10 liegt.

7. Bipolartransistorstruktur nach mindestens einem der Ansprüche 1 bis 6, **gekennzeichnet durch** eine zwischen dem Halbleitersubstrat (1) aus Silizium und der Transistorstruktur angeordneten Isolationsschicht (2) aus SiO$_2$.

8. Bipolartransistorstruktur nach mindestens einem der Ansprüche 1 bis 7, **dadurch gekennzeichnet**, daß die Kollektorschicht (3, 4) in leitender Verbindung mit dem Halbleitersubstrat (1) steht.

9. Bipolartransistorstruktur nach mindestens einem der Ansprüche 1 bis 8, **gekennzeichnet durch** aus Aluminium oder aus einer Aluminiumlegierung bestehende Anschlüsse (10).

10. Bipolartransistorstruktur nach mindestens einem der Ansprüche 1 bis 9, **gekennzeichnet durch** mit Arsen bzw. Bor dotierte Polysiliziumschichten (4, 6, 8), wobei die Dotierstoffe durch Ionenimplantation und nachträgliches Tempern eingebracht sind.

11. Bipolartransistorstruktur nach mindestens einem der Ansprüche 1 bis 10, **gekennzeichnet durch** eine Basisdotierung (6) von 10$^{18}$ bis 10$^{19}$ cm$^{-3}$.

12. Bipolartransistorstruktur nach mindestens einem der Ansprüche 1 bis 11, **dadurch gekennzeichnet**, daß die Polysiliziumschichten (4, 6, 8) durch Schockausheilen von im amorphen Zustand abgeschiedenen Siliziumschichten erzeugt sind.

13. Verfahren zum Herstellen einer Bipolartransistorstruktur nach mindestens einem der Ansprüche 1 bis 12, **gekennzeichnet durch** den Ablauf folgender Verfahrensschritte:

a) Erzeugung einer thermischen Oxidschicht (2) in einer Schichtdicke von 0,5 bis 1,0 μm auf einem dotierten Siliziumsubstrat (1),

b) Abscheidung einer ganzflächigen Tantaldisilizidschicht (3) und einer ganzflächigen, mit Arsen dotierten Polysiliziumschicht (4),

c) Strukturierung der als Kollektorzone (3, 4) dienenden Doppelschicht aus polykristallinem Silizium und Tantaldisilizid nach erfolgter Fotolacktechnik,

d) ganzflächige Abscheidung einer SiO$_2$-Schicht (5) und Strukturierung dieser Schicht (5) so, daß über der Kollektorzone (3, 4) der Basisbereich (6) freigeätzt wird,

e) Abscheidung einer ganzflächigen, mit Bor dotierten Polysiliziumschicht (6),

f) Strukturierung der als Basiszone dienenden bordotierten Polysiliziumschicht (6) nach erfolgter Fotolacktechnik,

g) ganzflächige Abscheidung einer SiO$_2$-Schicht (7) und Strukturierung der SiO$_2$-Schicht (7) so, daß die Basiszone (6) bis auf die Bereiche, die die über der Kollektorzone (3, 4) liegende Oxidschicht (5) überlappen, freigelegt ist,

h) Abscheidung einer ganzflächigen, mit Arsen dotierten Polysiliziumschicht (8) und einer ganzflächigen Tantaldisilizidschicht (9),

i) Strukturierung der als Emitterzone (8, 9) dienenden Doppelschicht nach erfolgter Fotolacktechnik so, daß die Emitterzone (8, 9) die Basiszone (6) überlappt,

j) Durchführung einer Fotolacktechnik zur Erzeugung des Kontaktloches (11) für den Kollektorzonenanschluß (3, 4) und des Kontaktloches für den Basiszonenanschluß,

k) Abscheidung einer ganzflächigen Kontaktmetallschicht (10) aus Aluminium oder einer Aluminiumlegierung und

l) Strukturierung der Kontaktmetallschicht (10) zur Bildung des Kollektor (C)-, Basis (B)- und Emitteranschlusses (E).

14. Verfahren nach Anspruch 13, **dadurch gekennzeichnet**, daß in Abänderung des Verfahrens bei den Verfahrenschritten h) und i) nur Polysilizium (8) abgeschieden und strukturiert wird und vor der Aluminiumabscheidung (10) nach Verfahrensschritt k) eine Tantaldisilizidabscheidung (9) erfolgt, und daß die Tantaldisilizidschicht (9) mit der Aluminiumschicht (10) zusammen strukturiert wird.

15. Verfahren nach Anspruch 13 oder 14, **dadurch gekennzeichnet**, daß in Abänderung des Verfahrens die Oxidation (2) nach Verfahrensschritt a) durch Verwendung einer Siliziumnitrid-Maske so geführt wird, daß die Transistorstruktur nur teilweise vom Substrat (1) durch eine Isolationsschicht (2) getrennt wird und ein n-dotiertes Substrat verwendet wird.

16. Verfahren nach mindestens einem der Ansprüche 13 bis 15, **dadurch gekennzeichnet**, daß in Abänderung des Verfahrens der Verfahrensschritt d) entfällt.

17. Verwendung von Bipolartransistorstrukturen nach mindestens einem der Ansprüche 1 bis 12 zur gleichzeitigen Herstellung von komplementären MOS-Transistorschaltungen (CMOS) und Bipolarschaltungen auf einem Substrat für hohe Schaltgeschwindigkeiten.

FIG 1

FIG 2

FIG 3

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | FR-A-2 390 004 (P. KUMURDJIAN) * Seite 3, Zeile 27 - Seite 4, Zeile 18; Ansprüche 1,4,6 * | 1 | H 01 L 29/72 H 01 L 29/04 |
| | --- | | |
| X | PATENTS ABSTRACTS OF JAPAN, Band 7, Nr. 174 (E-190)[1319], August 1983; & JP-A-58 79 760 (HITACHI) 13-05-1983 * Zusammenfassung * | 1 | |
| | --- | | |
| A | EP-A-0 066 810 (TOKYO SHIBAURA DENKI K.K.) * Ansprüche 8,9 * | 2 | |
| | --- | | |
| A | EP-A-0 078 221 (FAIRCHILD) * Ansprüche 1-3 * | 2 | |
| | ----- | | RECHERCHIERTE SACHGEBIETE (Int. Cl.4) |
| | | | H 01 L 29 |

Der vorliegende Recherchenbericht wurde für alle Patentansprüche erstellt.

| Recherchenort | Abschlußdatum der Recherche | Prüfer |
|---|---|---|
| DEN HAAG | 28-10-1986 | PELSERS L. |